# EUROPEAN PATENT APPLICATION

(11) **EP 4 435 139 A1**
(43) Date of publication of application: **25.09.2024**
(21) Application number: 22895557.1
(22) Date of filing: 11.11.2022
(51) Int. Cl.: C23C 14/06, C23C 14/08

(54) **SOLID LUBRICANT MATERIAL, SLIDING MEMBER AND METHOD FOR FORMING SOLID LUBRICANT MATERIAL**

(30) Priority: 16.11.2021 JP 2021186703
(71) Applicant: Idemitsu Kosan Co., Ltd., Tokyo 100-8321 (JP)
(72) Inventor: TAKENAKA, Issei, Tokyo 100-8321 (JP); MIYAGAWA, Yoshihide, Tokyo 100-8321 (JP)
(74) Representative: Vossius & Partner Patentanwälte Rechtsanwälte mbB
(86) International application number: PCT/JP2022/042155
(87) International publication number: WO 2023/090275

(57) **Abstract**

Provided is a solid lubricant having high durability. The solid lubricant comprises a material having a hexagonal crystal structure. A ratio of a plane other than (002) plane to (002) plane of the solid lubricant at an interface with a base material to be coated is higher than a ratio of a plane other than (002) plane to (002) plane on a surface of the solid lubricant. Alternatively, a ratio of a peak intensity of X-ray diffraction for the plane other than (002) plane to a peak intensity of X-ray diffraction for (002) plane of the solid lubricant at the interface with the base material is higher than a ratio of a peak intensity of X-ray diffraction for the plane other than (002) plane to a peak intensity of X-ray diffraction for (002) plane on the surface of the solid lubricant.

## Description

### Technical Field

The present invention relates to a solid lubricant, a slider, and a method for forming a solid lubricant.

### Background Art

As one way to save energy, reducing the frictional force of a movable part is exemplified. Various solid lubricants have been used for the purpose of reducing friction. Patent Literatures 1 and 2 below disclose zinc oxide coatings as solid lubricants. Patent Literature 1 discloses a low-friction ZnO coating including (002) and (103) planes and including (100), (101), (102) and (104) planes at a ratio less than that of the (002) and (103) planes in order to reduce friction.

### Citation List

### Patent Literature

Patent Literature 1: WO 2012/039264 A
Patent Literature 2: WO 2016/190375 A

### Summary

The friction coefficient of a solid lubricant is preferably low. In addition, improvement of durability of the solid lubricant is required. In particular, depending on the environment in which the solid lubricant is used, higher durability of the solid lubricant may be desired.

A solid lubricant according to one aspect comprises a material having a hexagonal crystal structure. In the solid lubricant, a ratio of a plane other than (002) plane to (002) plane at an interface with a base material to be coated is higher than a ratio of a plane other than (002) plane to (002) plane on a surface of the solid lubricant. Alternatively, a ratio of a peak intensity of X-ray diffraction for the plane other than (002) plane to a peak intensity of X-ray diffraction for (002) plane at the interface with the base material may be higher than a ratio of a peak intensity of X-ray diffraction for the plane other than (002) plane to a peak intensity of X-ray diffraction for (002) plane on the surface of the solid lubricant.

A method for forming a solid lubricant according to one aspect relates to forming a solid lubricant including a material having a hexagonal crystal structure. The method comprises a step of coating a solid lubricant including a material having a hexagonal crystal structure on a base material such that a ratio of a plane other than a (002) plane to the (002) plane at an interface with the base material to be coated is higher than a ratio of a plane other than a (002) plane to the (002) plane on a surface of the solid lubricant, or such that a ratio of a peak intensity of X-ray diffraction for the plane other than the (002) plane to a peak intensity of X-ray diffraction for the (002) plane at the interface with the base material is higher than a ratio of a peak intensity of X-ray diffraction for the plane other than the (002) plane to a peak intensity of X-ray diffraction for the (002) plane on the surface of the solid lubricant.

A slider according to one aspect comprises the solid lubricant mentioned above.

### Brief Description of Drawings

Fig. 1 is a schematic diagram illustrating an example of a configuration of a solid lubricant according to a first embodiment and a structure using the solid lubricant.
Fig. 2 is a graph showing results of X-ray diffraction for zinc oxide coatings as various solid lubricants in the vicinity of an interface with a base material.
Fig. 3 is a schematic diagram illustrating an example of a configuration of a solid lubricant according to a second embodiment and a structure using the solid lubricant.
Fig. 4 is a schematic diagram illustrating an example of a configuration of a solid lubricant according to a third embodiment and a structure using the solid lubricant.
Fig. 5 is a graph showing results of an X-ray diffraction test of a surface side of various zinc oxide coatings.
Fig. 6 is a view showing laser micrographs of surfaces of base materials in Example 2 and Reference Example 1 after reciprocating dynamic friction tests.
Fig. 7 is a graph showing measurement results of friction coefficients of the surfaces of base materials in Examples 1 and 2 and Reference Example 1 during reciprocating dynamic friction tests.

### Description of Embodiments

Hereinafter, embodiments will be described with reference to the drawings. In the following drawings, the same or similar parts are denoted by the same or similar reference numerals. However, it should be noted that the drawings are schematic, and ratios of dimensions and the like may be different from actual ones.

### [First Embodiment]

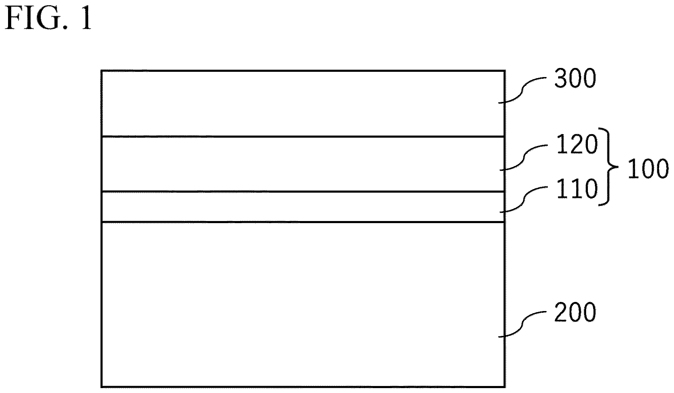

An example of a configuration of a solid lubricant according to a first embodiment and a structure using the solid lubricant will be described. Fig. 1 is a schematic diagram illustrating an example of a configuration of the solid lubricant according to the first embodiment and the structure using the solid lubricant.

The structure may have a base material 200, a solid lubricant 100 and a lubricant oil 300. The solid lubricant 100 is provided on the base material 200. The base material 200 is a material on which a solid lubricant is to be provided. The material constituting the base material 200 is not particularly limited, but may be, for example, a metal material such as a steel plate. In the example shown in Fig. 1, the lubricant oil 300 is provided on the solid lubricant. Alternatively, the lubricant oil 300 may not be used.

The solid lubricant 100 includes a material having a hexagonal crystal structure. For example, the solid lubricant 100 includes a material selected from the group consisting of ZnO, BeO, SiO₂, GeO₂, Al₂O₃, WO₃, MoO₃, and MoS₂.

The material having the hexagonal crystal structure is preferably an oxide material. Examples of the oxide material include ZnO, BeO, SiO₂, GeO₂, Al₂O₃, WO₃, and MoO₃. More preferably, the material constituting the solid lubricant 100 is zinc oxide (ZnO).

In the aspect shown in Fig. 1, the solid lubricant 100 may have a base layer 110 facing the base material 200 and a surface layer 120 at the surface side. However, it should be noted that the base layer 110 and the surface layer 120 may not be separated by a clear boundary.

The solid lubricant 100 can be formed by, for example, a deposition technique such as sputtering deposition. In this case, the base layer 110 and the surface layer 120 of the solid lubricant 100 may be, for example, layers formed under different deposition conditions each other.

The base layer 110 is located at an interface with the base material 200. The surface layer 120 faces the side opposite to the base layer 110. In the first embodiment, the crystal orientation of the base layer 110 is different from the crystal orientation of the surface layer 120.

More specifically, the ratio of planes other than (002) plane to (002) plane of the solid lubricant at the interface with the base material to be coated is higher than the ratio of planes other than (002) plane to (002) plane on the surface of the solid lubricant. In other words, the ratio of the peak intensity of X-ray diffraction for planes other than (002) plane to the peak intensity of X-ray diffraction for (002) plane of the solid lubricant at the interface with the base material to be coated is higher than the ratio of the peak intensity of X-ray diffraction for planes other than (002) plane to the peak intensity of X-ray diffraction for (002) plane on the surface of the solid lubricant.

Preferably, the ratio of (100) plane and (101) plane to (002) plane of the solid lubricant at the interface with the base material to be coated is higher than the ratio of (100) plane and (101) plane to (002) plane on the surface of the solid lubricant. In other words, the ratio of the peak intensity of X-ray diffraction for (100) plane and (101) plane to the peak intensity of X-ray diffraction for (002) plane of the solid lubricant at the interface with the base material to be coated is higher than the ratio of the peak intensity of X-ray diffraction for (100) plane and (101) plane to the peak intensity of X-ray diffraction for (002) plane on the surface of the solid lubricant.

(002) plane of the material having the hexagonal crystal structure is a Closest-packed plane, and it is considered that (002) plane of the material is a low-friction plane. Therefore, when most of the interface between the base material and the solid lubricant corresponds to (002) plane (low-friction plane) of the solid lubricant, it is considered that the solid lubricant is easily peeled off from the base material and that the durability of the solid lubricant is reduced. In the present embodiment, the interface between the base material and the solid lubricant contains a relatively large amount of planes other than (002) plane of the solid lubricant. Therefore, it is considered that the solid lubricant is hardly peeled off from the base material and that the durability of the solid lubricant is improved. In consideration of these actions, it is considered that the durability of the solid lubricant can be improved even if the lubricant oil is provided or is not provided on the surface of the solid lubricant.

On the other hand, the surface of the solid lubricant includes (002) plane at a relatively high ratio, and thus the low-friction property of the solid lubricant can be maintained.

The ratio of (002) plane and the peak intensity of X-ray diffraction for (002) plane in each layer of the solid lubricant can be changed by adjusting deposition conditions during depositing of the solid lubricant.

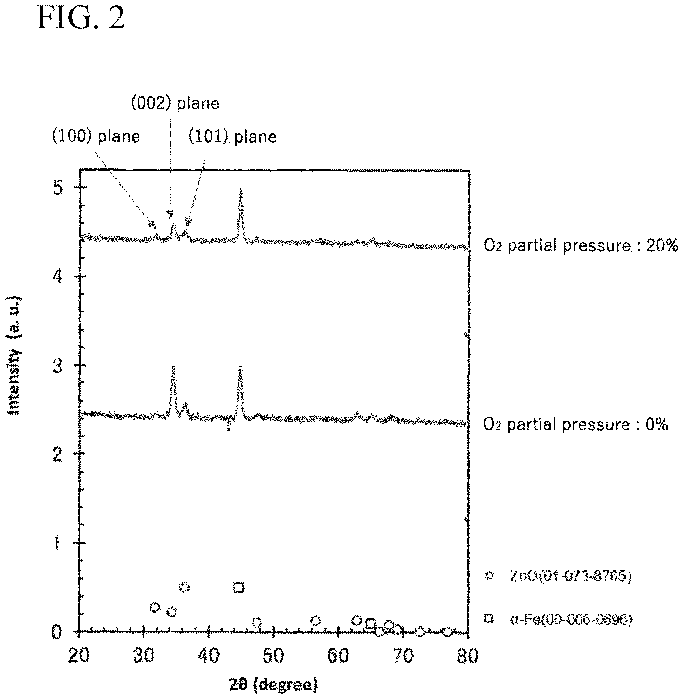

Fig. 2 is a table showing results of X-ray diffraction tests on zinc oxide coatings as the solid lubricant. An upper line in the graph of Fig. 2 shows a result when a zinc oxide coating was formed on the base material by a sputtering deposition method using a target material made of zinc oxide under the condition that the oxygen partial pressure relative to argon was 20%. A lower line in the graph of Fig. 2 shows a result when a zinc oxide coating was formed on the base material by a sputtering deposition method using a target material made of zinc oxide under the condition that the oxygen partial pressure relative to argon was 0% (condition not containing oxygen).

As shown in Fig. 2, it is found that the ratio of the peak intensity of X-ray diffraction for (100) plane and (101) plane to the peak intensity of X-ray diffraction for (002) plane is increased by increasing the oxygen partial pressure in the rare gas. This means that the ratio of (100) plane and (101) plane to (002) plane is high on the surface of the coating. As described above, adjusting the oxygen partial pressure during sputtering deposition can adjust the ratio of the peak intensity of X-ray diffraction for the plane other than (002) plane to the peak intensity of X-ray diffraction for (002) plane and the ratio of the planes other than (002) plane to (002) plane. Therefore, the above-described zinc oxide coating can be achieved by appropriately adjusting the oxygen partial pressure at the time of sputtering depositions of the base layer and the surface layer.

Next, a method for forming the solid lubricant will be described. A method for forming a solid lubricant includes a step of coating a solid lubricant on a base material such that the ratio of planes other than(002) plane to (002) plane at the interface with the base material to be coated is higher than the ratio of planes other than (002) plane to (002) plane on the surface of the solid lubricant, or such that the ratio of peak intensity of X-ray diffraction for the planes other than (002) plane to peak intensity of X-ray diffraction for (002) plane at the interface with the base material to be coated is higher than the ratio of peak intensity of X-ray diffraction for the plane other than (002) plane to peak intensity of X-ray diffraction for (002) plane on the surface of the solid lubricant.

Preferably, in the above step, the solid lubricant is coated on the base material such that the ratio of (100) plane and (101) plane to (002) plane at the interface with the base material to be coated is higher than the ratio of (100) plane and (101) plane to (002) plane on the surface of the solid lubricant, or such that the ratio of the peak intensity of X-ray diffraction for (100) plane and (101) plane to the peak intensity of X-ray diffraction for (002) plane at the interface with the base material to be coated is higher than the ratio of the peak intensity of X-ray diffraction for (100) plane and (101) plane to the peak intensity of X-ray diffraction for (002) plane on the surface of the solid lubricant.

In the first embodiment, the solid lubricant 100 is formed so as to have at least the base layer 110 located on the interface with the base material 200 and the surface layer 120 facing opposite to the base layer. In this case, the deposition condition for forming the surface layer 120 may be different from the deposition condition for forming the base layer 110.

The solid lubricant may be coated by any deposition technique such as a sputtering deposition method. The ratio of the planes other than (002) plane to the (002) plane in each layer of the solid lubricant and the ratio between the peak intensities of the X-ray diffraction for (002) plane and the plane other than (002) plane can be changed by adjusting deposition conditions at the time of coating the solid lubricant.

In one example, the solid lubricant is coated by a sputtering deposition method. In this case, the crystal orientation of the solid lubricant can be changed by changing the content of another gas relative to the rare gas during sputtering deposition between at a position close to the interface with the base material and at a position close to the surface of the solid lubricant.

When the solid lubricant has an oxide material, the content of oxygen relative to the rare gas during sputtering deposition at the position close to the interface with the base material is preferably higher than the content of oxygen relative to the rare gas during sputtering deposition at the position close to the surface of the solid lubricant. Thus, it possible to achieve the ratio of the planes other than (002) plane to (002) plane and the ratio between the peak intensities of the X-ray diffraction for (002) plane and the other planes in each layer of the solid lubricant as in the example of the zinc oxide deposition described above. It is also possible to adjust these ratios by changing the content of oxygen relative to the rare gas.

In the sputtering deposition method, the target material is not particularly limited as long as a solid lubricant can be formed. When the solid lubricant has an oxide material, the target material may be an oxide material containing molecules constituting the oxide material, or may be a material having a content in which oxygen is excluded from the molecules constituting the oxide material. From the viewpoint of reducing the content of oxygen relative to the gas around the target material, the target material may be a material containing the same molecule as the oxide material constituting the solid lubricant.

For example, when the solid lubricant is made of zinc oxide, the target material may be, for example, zinc oxide or zinc. From the viewpoint of reducing the content of oxygen relative to the gas around the target material, the target material is preferably zinc oxide.

The gas around the target material may be a rare gas or a mixture of oxygen and a rare gas. The rare gas may be, for example, argon.

### [Second Embodiment]

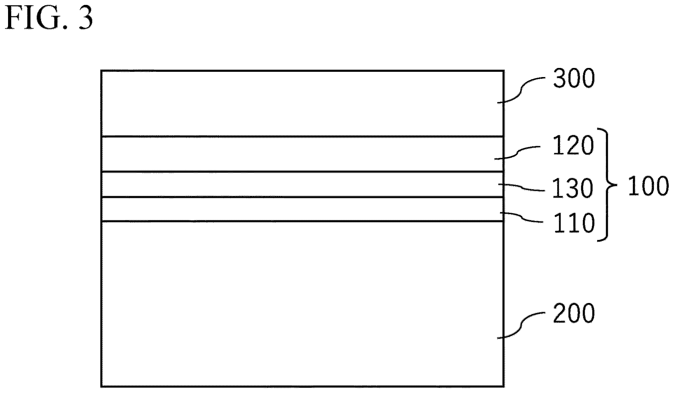

An example of a configuration of a solid lubricant according to a second embodiment and a structure using the solid lubricant will be described. Fig. 3 is a schematic diagram illustrating an example of a configuration of the solid lubricant according to the second embodiment and the structure using the solid lubricant. The same reference numerals are given to the same configurations as those of the first embodiment. It should be noted that the description of the same configuration as that of the first embodiment may be omitted.

In the second embodiment, the solid lubricant 100 may include the base layer 110, an intermediate layer 130, and the surface layer 120. The base layer 110 is a layer in contact with the base material 200. The surface layer 120 is a sliding surface that can slide with another member. The intermediate layer 130 is located between the base layer 110 and the surface layer 120.

The base layer 110, the intermediate layer 130 and the surface layer 120 may be, for example, layers formed under different deposition conditions each other. In Fig. 3, only one layer of the intermediate layer 130 is illustrated. Alternatively, the solid lubricant 100 may have a plurality of intermediate layers 130 between the base layer 110 and the surface layer 120. In this case, the plurality of intermediate layers 130 may be layers formed under different deposition conditions.

It should be noted that also in the second embodiment, the base layer 110, the intermediate layer 130, and the surface layer 120 may not be separated by a clear boundary.

In the second embodiment, the crystal orientation of the base layer 110 is different from the crystal orientation of the surface layer 120. The crystal orientation of the intermediate layer 130 may be different from the crystal orientation of the base layer 110 and the surface layer 120, and may be the same as the crystal orientation of one of the base layer 110 and the surface layer 120.

Specifically, also in the second embodiment, the ratio of the plane other than (002) plane to (002) plane of the solid lubricant at the interface (base layer) with the base material to be coated is higher than the ratio of the plane other than (002) plane to (002) plane on the surface (surface layer) of the solid lubricant. In other words, the ratio of the peak intensity of X-ray diffraction for the plane other than (002) plane to the peak intensity of X-ray diffraction for (002) plane of the solid lubricant at the interface with the base material to be coated is higher than the ratio of the peak intensity of X-ray diffraction for the plane other than (002) plane to the peak intensity of X-ray diffraction for (002) plane on the surface of the solid lubricant. As a result, similarly to the first embodiment, a solid lubricant having high durability can be expected.

### [Third Embodiment]

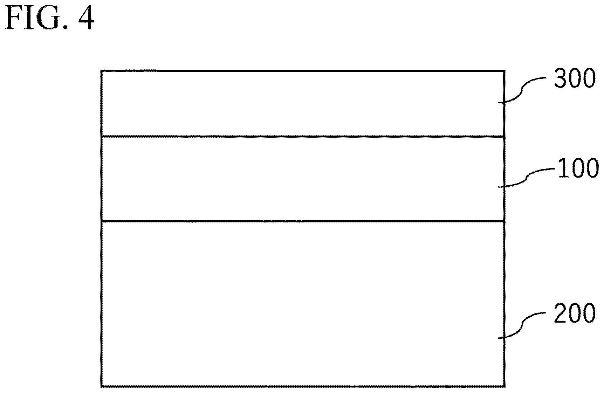

An example of a configuration of a solid lubricant according to a third embodiment and a structure using the solid lubricant will be described. Fig. 4 is a schematic diagram illustrating an example of a configuration of the solid lubricant according to the third embodiment and the structure using the solid lubricant. The same reference numerals are given to the same configurations as those of the first embodiment. It should be noted that the description of the same configuration as that of the first embodiment may be omitted.

In the third embodiment, the solid lubricant 100 is formed of a layer having no clear boundary. In the third embodiment, the crystal orientation of the material constituting the solid lubricant gradually changes in the thickness direction.

Even in this case, the ratio of the planes other than (002) plane to (002) plane of the solid lubricant at the interface with the base material to be coated is higher than the ratio of the planes other than (002) plane to (002) plane on the surface of the solid lubricant. In other words, the ratio of the peak intensity of X-ray diffraction for the planes other than (002) plane to the peak intensity of X-ray diffraction for (002) plane of the solid lubricant at the interface with the base material to be coated is higher than the ratio of the peak intensity of X-ray diffraction for the planes other than (002) plane to the peak intensity of X-ray diffraction for (002) plane on the surface of the solid lubricant. As a result, a solid lubricant having high durability can be expected.

The solid lubricant 100 according to the third embodiment can be formed by gradually changing the deposition conditions of the solid lubricant while depositing the solid lubricant. When the solid lubricant has an oxide material, the solid lubricant can be formed by gradually changing the content of oxygen relative to the rare gas during sputtering deposition while progressing the deposition of the solid lubricant. Specifically, the content of oxygen relative to the rare gas during sputtering deposition can be gradually reduced while the solid lubricant 100 is deposited. As a result, it is possible to achieve a solid lubricant in which the crystal orientation of the material constituting the solid lubricant gradually changes with the thickness.

### [Example 1]

A solid lubricant according to Example 1 will be described. In Example 1, a zinc oxide coating as a solid lubricant was provided on the base material. As illustrated in Fig. 1, the zinc oxide coating included the base layer and the surface layer. The base layer and the surface layer of the zinc oxide coating were formed by using "interback type sputtering device SIH-300 manufactured by ULVAC, Inc.". The target material was zinc oxide.

In Example 1, the gas for deposition at the time of forming the base layer of the zinc oxide coating was a mixture of an argon having a partial pressure of 80% and an oxygen having a partial pressure of 20% (refer to Table 1). In Example 1, the gas for deposition at the time of forming the surface layer is argon, and does not practically contain oxygen. The flow rate of the gas for deposition was 50 ml/min. The temperature for deposition was 25°C, and the pressure for deposition was 0.5 Pa. The discharge power at the time of forming the base layer was 200 W, and the discharge power at the time of forming the surface layer was 2000 W. The layer thickness of the base layer was 40 nm, and the layer thickness of the surface layer was 1700 nm. The layer thickness described above is a value measured by spectroscopic ellipsometry (hereinafter, the same shall apply).

### [Example 2]

A solid lubricant according to Example 2 will be described. In Example 2, a zinc oxide coating as a solid lubricant was provided on the base material. The zinc oxide coating according to Example 2 was formed under the same conditions as in Example 1 except for the layer thickness of the base layer of zinc oxide (refer to Table 1). In Example 2, the layer thickness of the base layer was 80 nm, and the layer thickness of the surface layer was 1700 nm.

### [Reference Example 1]

A solid lubricant according to Reference Example 1 will be described. In Reference Example 1, a zinc oxide coating as a solid lubricant was provided on the base material. The zinc oxide coating according to Reference Example 1 was formed under the same conditions as in Example 1 except for the component of the gas for deposition at the time of forming the base layer. In Reference Example 1, the gas for deposition at the time of forming the base layer and the surface layer was argon, and did not practically contain oxygen (refer to Table 1). In addition, in Reference Example 1, the layer thickness of the base layer was 60 nm, and the layer thickness of the surface layer was 1700 nm.

**(Table 1)**

| | Gas for deposition for forming base layer | Layer thickness of base layer | Gas for deposition for forming surface layer | Layer thickness of surface layer |
|---|---|---|---|---|
| Example 1 | Ar:O₂=80%:20% | 40nm | Ar:O₂=100%:0% | 1700nm |
| Example 2 | Ar:O₂=80%:20% | 80nm | Ar:O₂=100%:0% | 1700nm |
| Reference Example 1 | Ar:O₂=100%:0% | 60nm | Ar:O₂=100%:0% | 1700nm |

In Examples 1 and 2, the partial pressure of the oxygen in the gas for deposition at the time of forming the base layer is higher than the partial pressure of the oxygen in the gas for deposition at the time of forming the surface layer. Therefore, as described in Fig. 2, it is considered that the ratio of the planes other than (002) plane to (002) plane of zinc oxide at the interface with the base material to be coated is higher than the ratio of the planes other than (002) plane to (002) plane on the surface of zinc oxide. In other words, the ratio of the peak intensity of X-ray diffraction for the planes other than (002) plane to the peak intensity of X-ray diffraction for (002) plane of zinc oxide at the interface with the base material to be coated is higher than the ratio of the peak intensity of X-ray diffraction for the planes other than (002) plane to the peak intensity of X-ray diffraction for (002) plane on the surface of zinc oxide.

In Reference Example 1, it is considered that the ratio of the planes other than (002) plane to (002) plane of zinc oxide at the interface with the base material to be coated is substantially the same as the ratio of the planes other than (002) plane to (002) plane on the surface of zinc oxide. In other words, it is considered that the ratio of the peak intensity of X-ray diffraction for the planes other than (002) plane to the peak intensity of X-ray diffraction for (002) plane of zinc oxide at the interface with the base material to be coated is substantially the same as the ratio of the peak intensity of X-ray diffraction for the planes other than (002) plane to the peak intensity of X-ray diffraction for (002) plane on the surface of zinc oxide.

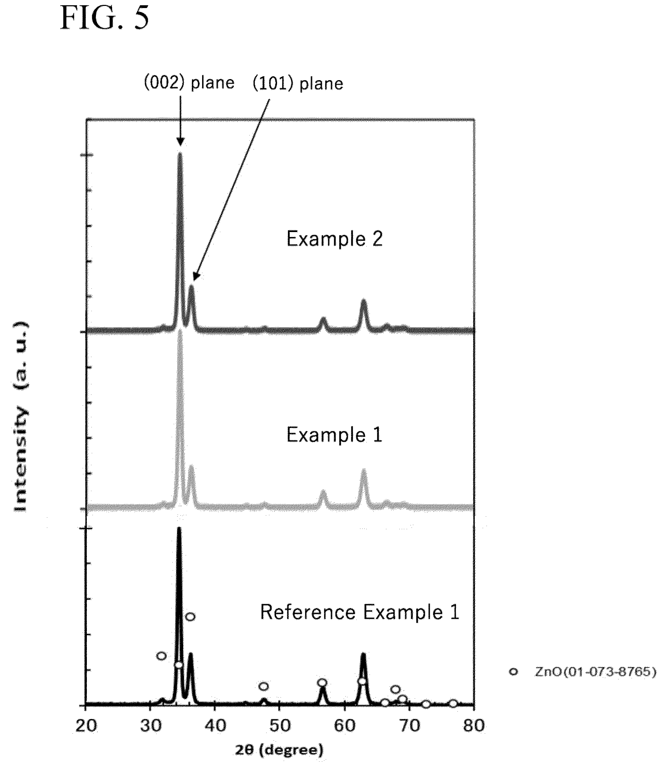

Fig. 5 is a graph showing results of an X-ray diffraction test of a surface side for various zinc oxide coatings. In Fig. 5, the X-ray diffraction test was performed by irradiating the surface side of the zinc oxide coatings according to Examples 1 and 2 and Reference Example 1 with an X-ray. In Examples 1 and 2 and Reference Example 1, the peak intensity of X-ray diffraction for (002) plane of zinc oxide is high. In Examples 1 and 2 and Reference Example 1, the surface layer of zinc oxide is formed under the same deposition condition. Therefore, the peak intensities of X-ray diffraction in Examples 1 and 2 and Reference Example 1 are substantially similar to each other.

On the other hand, as already described in Fig. 2, in the base layers in Examples 1 and 2, it is found that the ratio of the peak intensity of X-ray diffraction for (100) plane and (101) plane to the peak intensity of X-ray diffraction for the (002) plane is increased by increasing the oxygen partial pressure in the rare gas during depositing. Therefore, in Examples 1 and 2, it is found that the ratio of the peak intensity of X-ray diffraction for the planes other than (002) plane to the peak intensity of X-ray diffraction for (002) plane of zinc oxide at the interface with the base material to be coated is higher than the ratio of the peak intensity of X-ray diffraction for the planes other than (002) plane to the peak intensity of X-ray diffraction for (002) plane on the surface of zinc oxide. This means that the ratio of the planes other than the (002) plane to (002) plane at the interface with the base material to be coated is higher than the ratio of the planes other than (002) plane to (002) plane on the surface of the solid lubricant.

The base materials having the zinc oxide coatings according to Example 2 and Reference Example 1 were subjected to a reciprocating dynamic friction test. In the reciprocating dynamic friction test, a sphere made of a steel material (SUJ-2) having a diameter of 0.5 inches was reciprocated on a surface of each base material provided with the zinc oxide coating. Herein, the reciprocating dynamic friction test was performed in a state where a mechanical oil was applied onto the zinc oxide coating.

The sphere made of the steel material was reciprocated on the base material while being pressed against the base material with a load of 3 kgf. The temperature at the time of the test was room temperature. The stroke width of the sphere made of the steel material was 20 mm, and the stroke speed was 10 mm/s. In addition, the sphere made of the steel material was reciprocated on the base material 200 having a zinc oxide coating.

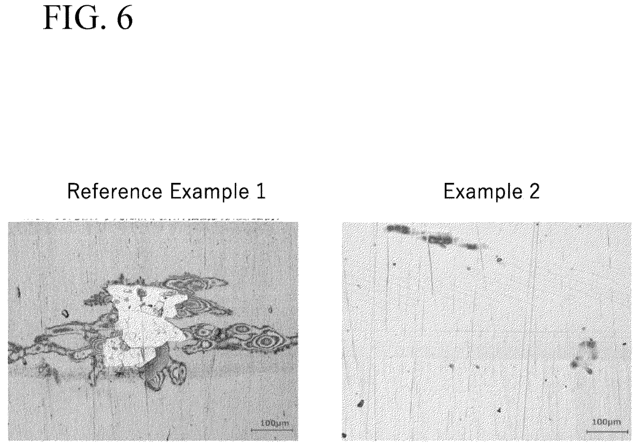

Fig. 6 is a view showing laser micrographs of surfaces of the base materials in Example 2 and Reference Example 1 after the reciprocating dynamic friction tests. Fig. 6 shows that the zinc oxide coating in Example 2 was hardly peeled off even after the reciprocating dynamic friction test. On the other hand, the zinc oxide coating according to Reference Example 1 was partially peeled off after the reciprocating dynamic friction test. From this result, it is found that the durability of the zinc oxide coating according to Example 2 is improved.

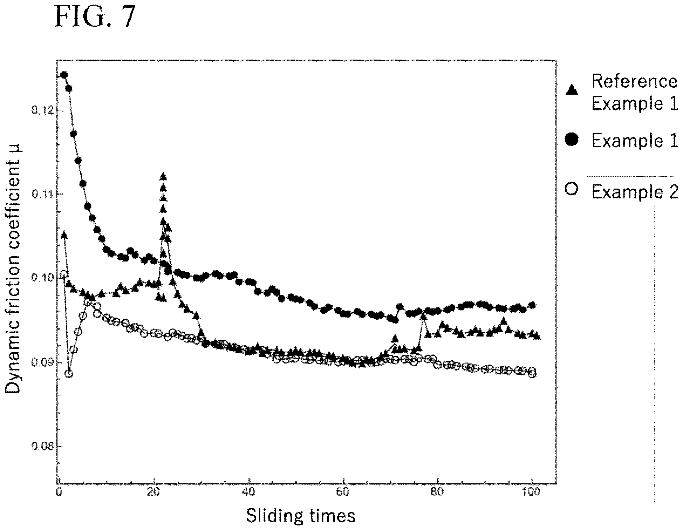

Fig. 7 is a graph showing measurement results of friction coefficients of the surfaces of the base materials in Examples 1 and 2 and Reference Example 1 during the reciprocating dynamic friction test. From Fig. 7, it is found that, in Examples 1 and 2, the friction coefficient is stable even when the number of sliding times of the sphere made of the steel material increases. On the other hand, in Reference Example 1, the friction coefficient suddenly increases when the number of sliding times exceeds 20 times, or gradually increases when the number of sliding times exceeds 70 times. As described above, the friction coefficients of the zinc oxide coatings according to Examples 1 and 2 maintain a more stable value than the friction coefficient of the zinc oxide coating according to Reference Example 1.

In addition, comparison between Example 1 and Example 2 shows that the friction coefficient of the zinc oxide coating maintains a lower value due to an increase in the layer thickness of the base layer. In particular, the friction coefficient of the zinc oxide coating according to Example 2 may stably maintain a low value.

The solid lubricant of the present invention can be suitably applied to a slider having a sliding surface. The solid lubricant is provided on the sliding surface of the slider, and the sliding surface corresponds to the surface of the base material 200 described above. Examples of the slider include a bearing, a seal, a flywheel, scissors, a plunger pump, a piston, a gear, a crankshaft, and an artificial joint.

This application claims priority based on Japanese Patent Application No. 2021-186703 filed on November 16, 2021, the entire contents of which are incorporated herein by reference.

As described above, the contents of the present invention have been disclosed through the embodiments, but it should not be understood that the description and the drawings constituting a part of the disclosure limit the present invention. From this disclosure, various alternative embodiments, examples, and operational techniques will become apparent to those skilled in the art. Therefore, the technical scope of the present invention is defined only by the matters specifying the invention according to the claims appropriate from the above description.

## Claims

1. A solid lubricant comprising a material having a hexagonal crystal structure, wherein
a ratio of a plane other than (002) plane to (002) plane at an interface with a base material to be coated is higher than a ratio of a plane other than (002) plane to (002) plane on a surface of the solid lubricant, or
a ratio of a peak intensity of X-ray diffraction for the plane other than (002) plane to a peak intensity of X-ray diffraction for (002) plane at the interface with the base material is higher than a ratio of a peak intensity of X-ray diffraction for the plane other than (002) plane to a peak intensity of X-ray diffraction for (002) plane on the surface of the solid lubricant.

2. The solid lubricant according to claim 1, wherein the material having the hexagonal crystal structure is an oxide material.

3. The solid lubricant according to claim 1, wherein the solid lubricant includes a material selected from a group consisting of ZnO, BeO, SiO₂, GeO₂, Al₂O₃, WO₃, MoO₃ and MoS₂.

4. The solid lubricant according to any one of claims 1 to 3, wherein
the solid lubricant includes at least a base layer located at the interface with the base material and a surface layer facing a side opposite to the base layer, and
a crystal orientation of the base layer is different from a crystal orientation of the surface layer.

5. The solid lubricant according to any one of claims 1 to 3, wherein a crystal orientation of the material constituting the solid lubricant gradually changes in a thickness direction.

6. The solid lubricant according to any one of claims 1 to 5, wherein
a ratio of (100) plane and (101) plane to (002) plane at the interface with the base material is higher than a ratio of (100) plane and (101) plane to (002) plane on the surface of the solid lubricant, or
a ratio of a peak intensity of X-ray diffraction for (100) plane and (101) plane to a peak intensity of X-ray diffraction for (002) plane at the interface with the base material is higher than a ratio of a peak intensity of X-ray diffraction for (100) plane and (101) plane to a peak intensity of X-ray diffraction for (002) plane on the surface of the solid lubricant.

7. A method for forming a solid lubricant, comprising a step of
coating a solid lubricant including a material having a hexagonal crystal structure on a base material such that a ratio of a plane other than (002) plane to (002) plane at an interface with the base material to be coated is higher than a ratio of a plane other than (002) plane to (002) plane on a surface of the solid lubricant, or such that a ratio of a peak intensity of X-ray diffraction for the plane other than (002) plane to a peak intensity of X-ray diffraction for (002) plane at the interface with the base material is higher than a ratio of a peak intensity of X-ray diffraction for the plane other than (002) plane to a peak intensity of X-ray diffraction for (002) plane on the surface of the solid lubricant.

8. The method for forming a solid lubricant according to claim 7, wherein
the solid lubricant is formed to include at least a base layer located at the interface with the base material and a surface layer facing a side opposite to the base layer, and
a deposition condition for forming the surface layer is different from a deposition condition for forming the base layer.

9. The method for forming a solid lubricant according to claim 7, wherein a deposition condition of the solid lubricant is gradually changed while the solid lubricant is deposited.

10. The method for forming a solid lubricant according to any one of claims 7 to 9, wherein in the step, the solid lubricant is coated on the base material such that a ratio of (100) plane and (101) plane to (002) plane at the interface with the base material is higher than a ratio of (100) plane and (101) plane to (002) plane on the surface of the solid lubricant, or a ratio of a peak intensity of X-ray diffraction for (100) plane (101) plane to a peak intensity of X-ray diffraction for (002) plane at the interface with the base material is higher than a ratio of a peak intensity of X-ray diffraction for (100) plane and (101) plane to a peak intensity of X-ray diffraction for (002) plane on the surface of the solid lubricant.

11. The method for forming a solid lubricant according to any one of claims 7 to 10, wherein
the solid lubricant is coated by a sputter deposition method, and
a content of oxygen relative to a rare gas during sputtering deposition at a position close to the interface with the base material is higher than a content of oxygen relative to a rare gas during sputtering deposition at a position close to the surface of the solid lubricant.

12. A slider comprising the solid lubricant according to any one of claims 1 to 6.
